# EUROPEAN PATENT APPLICATION

(11) **EP 4 329 017 A1**
(43) Date of publication of application: **28.02.2024**
(21) Application number: 22941855.3
(22) Date of filing: 17.06.2022
(51) Int. Cl.: H01M 4/66

(54) **PREPARATION METHOD FOR PRELITHIATED POSITIVE ELECTRODE CURRENT COLLECTOR, AND POSITIVE ELECTRODE CURRENT COLLECTOR AND LITHIUM-ION BATTERY**

(71) Applicant: Contemporary Amperex Technology Co., Limited, Ningde City, Fujian 352100 (CN)
(72) Inventor: ZHANG, Yuxi, Ningde, Fujian 352100 (CN); AI, Shaohua, Ningde, Fujian 352100 (CN); ZHOU, Xin, Ningde, Fujian 352100 (CN); CHEN, Yu, Ningde, Fujian 352100 (CN); ZENG, Qi, Ningde, Fujian 352100 (CN)
(74) Representative: Kraus & Lederer PartGmbB
(86) International application number: PCT/CN2022/099431
(87) International publication number: WO 2023/240593

(57) **Abstract**

The present application provides a method for preparing a prelithiated positive electrode current collector, the method comprising the following steps: gasifying a lithium source in an evaporation chamber filled with a protective gas; enabling an aluminum foil layer to pass through the evaporation chamber and depositing the metal lithium on a surface of the aluminum foil layer by means of vapor deposition; and transferring the aluminum foil layer deposited with the metal lithium to an annealing chamber filled with a protective gas and performing high-temperature annealing to form a lithium-aluminum alloy layer on the surface of the aluminum foil layer.

## Description

### Technical Field

The present invention relates to the technical filed of secondary batteries, and particularly relates to a method for preparing a prelithiated positive electrode current collector, a positive electrode current collector prepared by the method, and a lithium-ion battery having a positive electrode containing the positive electrode current collector.

### Background Art

In recent years, lithium-ion batteries have been rapidly developed in the fields of portable electronic products, new energy vehicles, smart power grids, distributed energy storage, etc., due to its advantages of excellent cycle life, relatively high energy density, environmental protection, etc. With the concern of people on the standby time of electronic portable products and the endurance mileage of new energy vehicles, higher requirements are continuously put forward on the energy density of lithium-ion batteries. Therefore, various new high-energy electrode active materials, such as a lithium-rich manganese-based material, high-capacity silicon, and a tin-based alloy material, have been developed to greatly increase the energy density of batteries. However, the first coulombic efficiency of these materials is relatively low, resulting in a large irreversible loss of the capacity of batteries. In this regard, it is necessary to make compensation for active lithium by means of a lithium compensation technique to ensure the effect on the energy density of lithium-ion batteries.

As a lithium compensation material, the metal lithium is theoretically the most ideal lithium compensation material due to its theoretical capacity reaching 3860 mAh/g. However, the metal lithium itself has an extremely strong reducing activity and easily reacts with oxygen and water in the air. The reaction rapidly occurs even in the case where the amount of water and oxygen is small, such that lithium is inactivated. Moreover, the reaction is substantially exothermic to cause a risk of fire and explosion. Therefore, the compensation for lithium using the metal lithium requires extremely severe environmental conditions such as an anhydrous oxygen-free environment or protection with a protective gas. Thus, many techniques for lithium compensation with a lithium compound have also been developed.

As a technique for lithium compensation using a lithium compound, a solution of adding a lithium compensation additive has been proposed. For example, an aluminum foil is imparted with a lithium compensation function by applying a layer of coating containing a lithium compound selected from LiO₂, Li₂O₂, Li₂S, Li₃N, LiN₃, Li₂C₂O₄, Li₂C₃O₅, Li₂C₄O₆, etc., or lithium-rich lithium nickelate as a lithium compensation additive on the surface of the aluminum foil. However, such a lithium compensation method has various drawbacks, such as the fact that lithium compounds easily decompose, or are reactive with water to release harmful gases, or are easily oxidized and inactivated, or require inactive materials such as binders and conductive agents, and the fact that the lithium compensation efficiency is reduced.

### Summary of the Invention

In view of the above issues, the present invention aims to provide a method for preparing a prelithiated positive electrode current collector with a simple preparation process, a positive electrode current collector prepared by the method with a simple structure and a lithium compensation function, and a lithium-ion battery having a positive electrode comprising the positive electrode current collector.

The present inventors have conducted intensive studies to solve the above-mentioned problems. As a result, it has been found that when a layer of the metal lithium is deposited on a surface of an aluminum foil layer in advance by using a vapor deposition technique, and a specific annealing treatment is then performed after deposition, a lithium-aluminum alloy layer can be generated on the aluminum foil layer without a conductive agent and a binder. The lithium-aluminum alloy layer is not easy to oxidize. When the aluminum foil layer formed with the lithium-aluminum alloy layer is used as a positive electrode current collector, since the lithium aluminum alloy layer is prelithiated in advance, efficient compensation for lithium can be achieved, thus completing the present invention.

That is, a first aspect of the present invention provides a method for preparing a prelithiated positive electrode current collector, the method comprising the following steps: gasifying a lithium source in an evaporation chamber filled with a protective gas; enabling an aluminum foil layer to pass through the evaporation chamber and depositing the metal lithium on a surface of the aluminum foil layer by means of vapor deposition; and transferring the aluminum foil layer deposited with the metal lithium to an annealing chamber filled with a protective gas and performing high-temperature annealing to form a lithium-aluminum alloy layer on the surface of the aluminum foil layer.

In some embodiments, the evaporation chamber is evacuated to a vacuum degree of 10⁻⁶ to 10² Pa, the lithium source is heated to 300-800°C, and the lithium source is gasified; optionally, the evaporation chamber is evacuated to a vacuum degree of 10⁻² to 10 Pa; and optionally, the lithium source is heated to 500-750°C.

In some embodiments, the lithium source is heated at a heating rate of 0.1-10°C/min; and optionally, the lithium source is heated at a heating rate of 1-5°C/min.

In some embodiments, the aluminum foil layer is passed through the evaporation chamber at a speed of 0.1-100 m/min; and optionally, the aluminum foil layer is passed through the evaporation chamber at a speed of 1-30 m/min.

In some embodiments, during the high-temperature annealing, heating same to the highest temperature of 200-600°C at a heating rate of 0.1-10°C/min, maintaining the temperature for a time of 0.1-24 hours, and then cooling same to room temperature at a cooling rate of 0.1-5°C/min.

In some embodiments, during the high-temperature annealing, the heating rate is 0.5-3°C/min;
the highest temperature is 400-500°C; the temperature maintaining time is 2-4 hours; and the cooling rate is 0.5-2°C/min.

In some embodiments, the lithium source is metal lithium powder, metal lithium strips or metal lithium wires; and the above-mentioned protective gas is argon or helium.

In some embodiments, the thickness of the above-mentioned aluminum foil layer is 5-50 µm, optionally 8-20 µm; and the thickness of the above-mentioned lithium-aluminum alloy layer is 0.1-10 µm, optionally 0.3-3.5 µm.

A second aspect of the present invention provides a positive electrode current collector obtained by using the preparation method of the first aspect of the present invention, the positive electrode current collector comprising an aluminum foil layer and a lithium-aluminum alloy layer formed on the aluminum foil layer.

A third aspect of the present invention provides a lithium-ion battery at least containing a positive electrode plate, a separator, a negative electrode plate, and an electrolyte solution, wherein the positive electrode plate comprises a positive electrode current collector obtained by using the preparation method of the first aspect of the present application or the positive electrode current collector of the second aspect of the present application.

In some embodiments, a positive electrode active substance in the above-mentioned positive electrode plate is at least one selected from lithium iron phosphate, lithium nickel cobalt manganate, lithium cobalt, lithium manganate, lithium nickelate, and lithium rich manganese materials.

In some embodiments, a negative electrode active substance in the above-mentioned negative electrode plate is at least one selected from graphite, soft carbon, hard carbon, silicon, and silicon monoxide.

A fourth aspect of the present invention further provides a battery module comprising the lithium-ion battery of the third aspect of the present invention.

A fifth aspect of the present invention further provides a battery pack comprising the battery module of the fourth aspect of the present invention.

A sixth aspect of the present invention further provides a power consuming device comprising at least one selected from the lithium-ion battery of the third aspect of the present invention, the battery module of the fourth aspect of the present invention, or the battery pack of the fifth aspect of the present invention.

### Effects of the Invention

By means of the method for preparing a prelithiated positive electrode current collector according to the present invention, the metal lithium deposited on the aluminum foil can be converted into a lithium-aluminum alloy by a simple process without the need for other auxiliary agents such as a binder and a conductive agent. When used as a positive electrode current collector, it has a high lithium compensation efficiency and stable chemical properties, and does not easily react with water and oxygen in the air, such that the positive electrode current collector has a high process safety, low costs, and easy industrial production.

### Brief Description of the Drawings

Fig. 1 is a schematic diagram of a prelithiated positive electrode current collector of an embodiment of the present application.
Fig. 2 is a schematic diagram of a lithium-ion battery of an embodiment of the present application.
Fig. 3 is an exploded view of the lithium-ion battery of the embodiment of the present application shown in Fig. 2.
Fig. 4 is a schematic diagram of a battery module of an embodiment of the present application.
Fig. 5 is a schematic diagram of a battery pack of an embodiment of the present application.
Fig. 6 is an exploded view of the battery pack of the embodiment of the present application shown in Fig. 5.
Fig. 7 is a schematic diagram of a power consuming device using the lithium-ion battery of an embodiment of the present application as a power source.

List of reference numerals:
101: aluminum foil layer; 102: lithium-aluminum alloy layer; 1: battery pack; 2: upper box body; 3: lower box body; 4: battery module; 5: lithium-ion battery; 51: housing; 52: electrode assembly; 53: cover plate.

### Detailed Description of Embodiments

Hereinafter, embodiments of the method for preparing a positive electrode current collector, the positive electrode current collector obtained by using the preparation method, the lithium-ion battery, the battery module, the battery pack, and the power consuming device of the present application are described in detail and specifically disclosed with reference to the accompanying drawings as appropriate. However, unnecessary detailed illustrations may be omitted in some instances. For example, there are situations where detailed description of well-known items and repeated description of actually identical structures are omitted. This is to prevent the following description from being unnecessarily verbose, and facilitates understanding by those skilled in the art. Moreover, the accompanying drawings and the descriptions below are provided for enabling those skilled in the art to fully understand the present application, rather than limiting the subject matter disclosed in the claims.

The "ranges" disclosed in the present application are defined in the form of lower and upper limits. A given range is defined by selecting a lower limit and an upper limit, and the selected lower and upper limits defining the boundaries of the particular range. Ranges defined in this manner may be inclusive or exclusive, and may be arbitrarily combined, that is, any lower limit may be combined with any upper limit to form a range. For example, if the ranges of 60-120 and 80-110 are listed for a particular parameter, it should be understood that the ranges of 60-110 and 80-120 are also contemplated. Additionally, if minimum range values 1 and 2 are listed and maximum range values 3, 4, and 5 are listed, the following ranges are all contemplated: 1-3, 1-4, 1-5, 2-3, 2-4 and 2-5. In the present application, unless stated otherwise, the numerical range "a-b" denotes an abbreviated representation of any combination of real numbers between a and b, where both a and b are real numbers. For example, the numerical range "0-5" means that all the real numbers between "0-5" have been listed herein, and "0-5" is just an abbreviated representation of combinations of these numerical values. In addition, when a parameter is expressed as an integer ≥ 2, it is equivalent to disclosing that the parameter is, for example, an integer of 2, 3, 4, 5, 6, 7, 8, 9, 10, 11, 12, etc.

All the embodiments and optional embodiments of the present application can be combined with one another to form new technical solutions, unless otherwise stated.

All the technical features and optional technical features of the present application can be combined with one another to form a new technical solution, unless otherwise stated.

Unless otherwise stated, all the steps of the present application may be performed sequentially or randomly, preferably sequentially. For example, the method comprising steps (a) and (b) indicates that the method may comprise steps (a) and (b) performed sequentially, or may also comprise steps (b) and (a) performed sequentially. For example, reference to "the method may further comprise step (c)" indicates that step (c) may be added to the method in any order, e.g., the method may comprise steps (a), (b), and (c), steps (a), (c), and (b), or also steps (c), (a), and (b), etc.

The terms "comprise" and "include" mentioned in the present application are openended or may also be closed-ended, unless otherwise stated. For example, "comprise" and "include" may mean that other components not listed may further be comprised or included, or only the listed components may be comprised or included.

In the present application, the term "or" is inclusive unless otherwise specified. For example, the phrase "A or B" means "A, B, or both A and B". More specifically, the condition "A or B" is satisfied by any one of the following: A is true (or present) and B is false (or not present); A is false (or not present) and B is true (or present); or both A and B are true (or present).

A first aspect of the present invention provides a method for preparing a prelithiated positive electrode current collector, the method comprising the following steps: gasifying a lithium source in an evaporation chamber filled with a protective gas; enabling an aluminum foil layer to pass through the evaporation chamber and depositing the metal lithium on a surface of the aluminum foil layer by means of vapor deposition; and transferring the aluminum foil layer deposited with the metal lithium to an annealing chamber filled with a protective gas and performing high-temperature annealing to form a lithium-aluminum alloy layer on the surface of the aluminum foil layer.

According to the method for preparing a prelithiated positive electrode current collector of the present invention, since the high-temperature annealing process is performed after the metal lithium layer is formed, the above-mentioned deposited metal lithium layer can fully react with aluminum on the surface of the aluminum foil to form the lithium-aluminum alloy layer. A high capacity can be and a high lithium compensation efficiency can be achieved, the chemical properties of the formed lithium-aluminum alloy layer are stable, no safety problems can be caused, and large-scale industrial production is facilitated.

In the method for preparing a prelithiated positive electrode current collector of the present invention, the thickness of the aluminum foil layer used is 5-50 µm, preferably 8-20 µm, and may be appropriately selected as necessary. When the thickness of the above-mentioned aluminum foil layer is less than 5 µm, the mechanical properties of the obtained positive electrode current collector may be insufficient; and when the thickness of the above-mentioned aluminum foil layer is greater than 50 µm, the weight of the current collector increases, the energy density decreases on the contrary, and the cost also increases.

In the method for preparing a prelithiated positive electrode current collector of the present invention, metal lithium products in various forms, such as metal lithium powder, metal lithium strips or metal lithium wires, may be used as lithium sources.

In the method for preparing a prelithiated positive electrode current collector of the present invention, the above-mentioned process is formed in the presence of a protective gas in order to prevent lithium from being oxidized. Specifically, the evaporation chamber and the annealing chamber are filled with a protective gas. The above-mentioned protective gas is preferably an inert gas. Examples of the inert gas may be helium and argon.

In the method for preparing a prelithiated positive electrode current collector of the present invention, the above-mentioned evaporation chamber is evacuated to a vacuum degree of 10⁻⁷ to 10² Pa, the above-mentioned lithium source is heated to 300-800°C, and the above-mentioned lithium source is gasified, and preferably, the above-mentioned evaporation chamber is evacuated to a vacuum degree of 10⁻² to 10 Pa and the above-mentioned lithium source is heated to 500-750°C.

It should be noted that the evacuation step is performed in an environment where the lithium source is in the evaporation chamber filled with the protective gas, such that the vacuum degree value does not cause oxidation of the lithium source and can be selected by those skilled in the art as necessary. However, an excessively high vacuum degree imposes higher requirements on equipment; and an excessively low vacuum degree requires a higher heating temperature to gasify the above-mentioned lithium source. Therefore, in the method for preparing an alloy aluminum foil with a prelithiation function of the present invention, the vacuum degree within the above-mentioned range is preferred in terms of process operability and costs.

During the gasification of the lithium source, the lithium source is heated in accordance with the set vacuum degree. When the heating temperature is less than 300°C, the lithium source cannot be fully gasified, preferably, the lower limit of the heating temperature is 500°C. In addition, at the above-mentioned vacuum degree, the lithium source is relatively easily gasified, and the upper limit of the heating temperature may be set to 800°C, more preferably 750°C in terms of costs. During the heating of the lithium source, the heating rate can be set to 0.1-10°C/min, preferably to 1-5°C/min.

When the aluminum foil layer passes through the evaporation chamber, the speed at which the above-mentioned aluminum foil layer passes through the evaporation chamber may be appropriately set according to the required amount of the metal lithium. For example, the above-mentioned aluminum foil layer may pass through the evaporation chamber at a speed of 0.1-100 m/min, preferably 1-30 m/min to deposit a certain amount of the metal lithium on the surface of the aluminum foil layer by means of vapor deposition. By properly adjusting the speed at which the aluminum foil layer passes through the evaporation chamber, the amount of metal lithium deposition can be adjusted to form the desired thickness, and a suitable lithium-aluminum alloy layer can be formed after the subsequent high-temperature annealing step.

After the metal lithium is deposited on the surface of the above-mentioned aluminum foil layer, the aluminum foil layer deposited with the metal lithium is transferred to an annealing chamber filled with a protective gas and high-temperature annealing is performed to form a lithium-aluminum alloy layer on the surface of the above-mentioned aluminum foil layer.

During high-temperature annealing, the aluminum foil is heated to 200-600°C at a heating rate of 0. 1-10°C/min, and the temperature is maintained for 0.1-24 hours and then lowered to room temperature at a cooling rate of 0.1-5°C/min.

By means of the high-temperature annealing under the above-mentioned annealing conditions, the crystal phase structure can be adjusted by annealing to eliminate structural defects, such that the metal lithium layer deposited on the aluminum foil can form a uniform lithium-aluminum alloy phase (Al₃Li) from the surface layer to the surface of the aluminum foil, and the metal lithium can remain as little as possible. When the aluminum foil layer formed with the lithium-aluminum alloy layer is used as a positive electrode current collector, a formation reaction can occur rapidly and smoothly during charging and discharging of a lithium-ion battery; in addition, safety is ensured, the lithium compensation efficiency is improved, and a high energy density is ensured.

During high-temperature annealing, when the heating rate and the cooling rate are too low, the time for reaching the highest temperature and the time for resuming room temperature become excessively long, which is not beneficial to the production efficiency; and an excessively high heating rate and cooling rate are not favorable for converting the metal lithium into a lithium-aluminum alloy, resulting in insufficient conversion. Therefore, preferably, the heating rate is set to 0.5-3°C/min and the cooling rate is set to 0.5-2°C/min.

During high-temperature annealing, when the reached maximum temperature is too low, a longer temperature maintaining time is needed. Besides, the metal lithium is not easily fully converted into the lithium-aluminum alloy, remaining a large amount of the metal lithium and reducing the production efficiency. When the reached maximum temperature is too high, the deposited metal lithium evaporates and the thickness of the obtained lithium-aluminum alloy layer decreases on the contrary. Therefore, preferably, the aluminum foil is heated to 400-500°C and maintained for 2-4 hours.

After the above-mentioned high-temperature annealing, the metal lithium layer on the aluminum foil layer is converted into the lithium-aluminum alloy layer. The thickness of the formed lithium-aluminum alloy layer is 0.1-10 µm, preferably 0.3-3.5 µm, more preferably 0.3-3 µm. The above-mentioned lithium metal layer is converted into the lithium-aluminum alloy layer by means of the annealing process, the composition of the alloy layer can be determined by measuring the contents of aluminum and lithium through surface EDS surface scanning, and the thickness of the alloy layer can be confirmed by measuring the change in the content of the element lithium through cross-sectional EDS line scanning.

When the thickness of the above-mentioned lithium-aluminum alloy layer is less than 0.1 µm, the content of lithium in the entire aluminum foil layer formed with the lithium-aluminum alloy layer is low, and the release amount of lithium ions is insufficient, and the aluminum foil layer formed with the lithium aluminum alloy layer, when used as a positive electrode current collector, cannot achieve a satisfactory lithium compensation effect. When the thickness of the above-mentioned lithium-aluminum alloy layer is greater than 10 µm, a large amount of the metal lithium may remain in the lithium-aluminum alloy layer even after the high-temperature annealing process, and the metal lithium is liable to react with water and oxygen in the air to lower the lithium compensation effect. Besides, the remaining metal lithium may cause the aluminum foil to become brittle, which causes reduced strength and thus technological problems, and this is not preferred in terms of costs. Furthermore, when the aluminum foil layer formed with an excessively thick lithium-aluminum alloy layer is used as a positive electrode current collector, the release amount of lithium ions is excessive, and problems such as lithium dendrites are caused. By controlling the thickness of the lithium-aluminum alloy layer within the above-mentioned range, lithium can be appropriately compensated for when the aluminum foil layer formed with the lithium-aluminum alloy layer is used as a positive electrode current collector.

A second aspect of the present invention provides a positive electrode current collector obtained by using the preparation method of the first aspect of the present invention, the positive electrode current collector comprising an aluminum foil layer and a lithium-aluminum alloy layer formed on the above aluminum foil layer.

A third aspect of the present invention provides a lithium-ion battery at least containing a positive electrode plate, a separator, a negative electrode plate, and an electrolyte solution, wherein the positive electrode plate comprises a positive electrode current collector obtained by using the preparation method of the first aspect of the present application or the positive electrode current collector of the second aspect of the present application.

A fourth aspect of the present invention further provides a battery module comprising the lithium-ion battery of the third aspect of the present invention.

A fifth aspect of the present invention further provides a battery pack comprising the battery module of the fourth aspect of the present invention.

A sixth aspect of the present invention further provides a power consuming device comprising at least one selected from the lithium-ion battery of the third aspect of the present invention, the battery module of the fourth aspect of the present invention, or the battery pack of the fifth aspect of the present invention.

In addition, the lithium-ion battery, the battery module, the battery pack, and the power consuming device of the present application will be described below by referring to the accompanying drawings as appropriate.

In an embodiment of the present application, a lithium-ion battery is provided.

The lithium-ion battery comprises a positive electrode plate, a negative electrode plate, an electrolyte, and a separator. During the charge/discharge of the battery, active ions are intercalated and de-intercalated back and forth between the positive electrode plate and the negative electrode plate. The electrolyte functions to conduct ions between the positive electrode plate and the negative electrode plate. The separator is arranged between the positive electrode plate and the negative electrode plate and mainly functions to prevent the positive and negative electrodes from short-circuiting while enabling ions to pass through.

### [Positive electrode plate]

The positive electrode plate comprises the prelithiated positive electrode current collector of the present application and a positive electrode material layer arranged on at least one surface of the positive electrode current collector.

As an example, the positive electrode current collector has two surfaces opposite in its own thickness direction, and the positive electrode material layer is arranged on either or both of the two opposite surfaces of the positive electrode current collector.

A positive electrode active substance well known in the art for batteries can be used in the positive electrode material layer. In some embodiments, a positive electrode active substance in the above positive electrode plate is at least one selected from lithium iron phosphate, lithium nickel cobalt manganate, lithium cobalt, lithium manganate, lithium nickelate, and lithium rich manganese materials.

In some embodiments, the positive electrode material layer may furthher comprise optionally a binder. As an example, the above-mentioned binder may include at least one of polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer, and a fluorine-containing acrylate resin.

In some embodiments, the positive electrode material layer may further comprise optionally a conductive agent. As an example, the above-mentioned conductive agent may include at least one of superconducting carbon, acetylene black, carbon black, Ketjen black, carbon dots, carbon nanotubes, graphene, and carbon nanofibers.

In some embodiments, the positive electrode plate can be prepared by dispersing the above-mentioned components for preparing positive electrode plates, for example, the positive electrode active substance, the conductive agent, the binder and any other components, in a solvent (e.g. N-methylpyrrolidone) to form a positive electrode slurry; and coating the prelithiated positive electrode current collector of the present invention with the positive electrode slurry, and then performing procedures such as drying and cold pressing to obtain the positive electrode plate.

### [Negative electrode plate]

The negative electrode plate comprises a negative electrode current collector and a negative electrode material layer arranged on at least one surface of the negative electrode current collector.

As an example, the negative electrode current collector has two opposite surfaces in its own thickness direction, and the negative electrode material layer is arranged on either or both of the two opposite surfaces of the negative electrode current collector.

In some embodiments, the negative electrode current collector can be a metal foil or a composite current collector. For example, as a metal foil, a copper foil can be used. The composite current collector may comprise a polymer material substrate layer and a metal layer formed on at least one surface of the polymer material substrate. The composite current collector may be formed by forming a metal material (copper, a copper alloy, nickel, a nickel alloy, titanium, a titanium alloy, silver, a silver alloy, etc.) on the polymer material substrate (e.g., polypropylene (PP), polyethylene terephthalate (PET), polybutylene terephthalate (PBT), polystyrene (PS), or polyethylene (PE)).

In some embodiments, a negative electrode active substance in the above negative electrode plate is at least one selected from graphite, soft carbon, hard carbon, silicon, and silicon monoxide.

In some embodiments, the negative electrode material layer may further comprise optionally a binder. The above-mentioned binder may be selected from at least one of styrene butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA) and carboxymethyl chitosan (CMCS).

In some embodiments, the negative electrode material layer may further comprise optionally a conductive agent. The conductive agent may be selected from at least one of superconductive carbon, acetylene black, carbon black, Ketjen black, carbon dots, carbon nanotubes, graphene, and carbon nanofibers.

In some embodiments, the negative electrode material layer may further comprise optionally other auxiliary agents, such as a thickener (e.g., sodium carboxymethylcellulose (CMC-Na)).

In some embodiments, a dispersant may be further used during the preparation of the negative electrode material layer. The dispersant is used to improve dispersion uniformity and coating properties and can be a dispersant commonly used in the field of batteries, for example, a polymeric dispersant. The polymeric dispersant can be, but is not limited to, polyvinyl alcohol, modified polyvinyl alcohols having functional groups other than hydroxyl, for example, acetyl, sulfo, carboxyl, carbonyl and amino, polyvinyl alcohol-based resins modified with various salts, other polyvinyl alcohol-based resins modified with anions or cations, polyvinyl alcohol-based resins modified by acetalation with aldehydes, or various (meth)acrylic-based polymers, polymers derived from ethylenically unsaturated hydrocarbons, cellulose-based resins, etc., or copolymers thereof. The polymeric dispersants may be used alone or in combination of two or more.

In some embodiments, the negative electrode plate can be prepared by dispersing the above-mentioned components for preparing negative electrode plates, such as the negative electrode active substance, the conductive agent, the binder and any other components, in a solvent (e.g., deionized water) to form a negative electrode slurry; and coating a negative electrode current collector with the negative electrode slurry, and then performing procedures such as drying and cold pressing to obtain the negative electrode plate.

### [Electrolyte]

The electrolyte functions to conduct ions between the positive electrode plate and the negative electrode plate. The type of the electrolyte is not specifically limited in the present application and can be selected as necessary. For example, the electrolyte may be in a liquid state, a gel state or an all-solid state.

In some embodiments, an electrolyte solution is used as the above-mentioned electrolyte. The above-mentioned electrolyte solution comprises an electrolyte salt and a solvent.

In some embodiments, the electrolyte salt may be selected from at least one of lithium hexafluorophosphate, lithium tetrafluoroborate, lithium perchlorate, lithium hexafluoroarsenate, lithium bisfluorosulfonimide, lithium bis(trifluoromethanesulfonimide), lithium trifluoromethanesulfonate, lithium difluorophosphate, lithium difluorooxalatoborate, lithium bis(oxalato)borate, lithium bisoxalatodifluorophosphate, and lithium tetrafluorooxalatophosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, ethyl methyl sulfone, and diethyl sulfone.

In some embodiments, the above-mentioned electrolyte solution may further comprise optionally an additive. For example, the additive may include a negative electrode film-forming additive and a positive electrode film-forming additive, and may further include an additive that can improve certain performances of the battery, such as an additive that improves the overcharge performance of the battery, or an additive that improves the high-temperature or low-temperature performance of the battery.

### [Separator]

In the present application, the lithium-ion battery further comprises a separator, wherein the positive electrode plate, the negative electrode plate, and the separator are manufactured into an electrode assembly having a wound structure by means of a winding process. The type of the separator is not particularly limited in the present application, and any well-known porous-structure separator with good chemical stability and mechanical stability may be selected.

In some embodiments, the material of the separator may be selected from at least one of glass fibers, woven fabrics, polyethylene, polypropylene, and polyvinylidene fluoride. The separator may be either a single-layer film or a multi-layer composite film and is not particularly limited. When the separator is a multi-layer composite film, the materials in the respective layers may be same or different and are not particularly limited.

In some embodiments, the lithium-ion battery may comprise an outer package. The outer package may be used to encapsulate the above-mentioned electrode assembly and electrolyte.

In some embodiments, the outer package of the lithium-ion battery may be a hard shell, for example, a hard plastic shell, an aluminum shell, or a steel shell. The outer package of the lithium-ion battery may also be a soft bag, such as a pouch-type soft bag. The material of the soft bag may be plastics, examples of which may be polypropylene, polybutylene terephthalate, polybutylene succinate, etc.

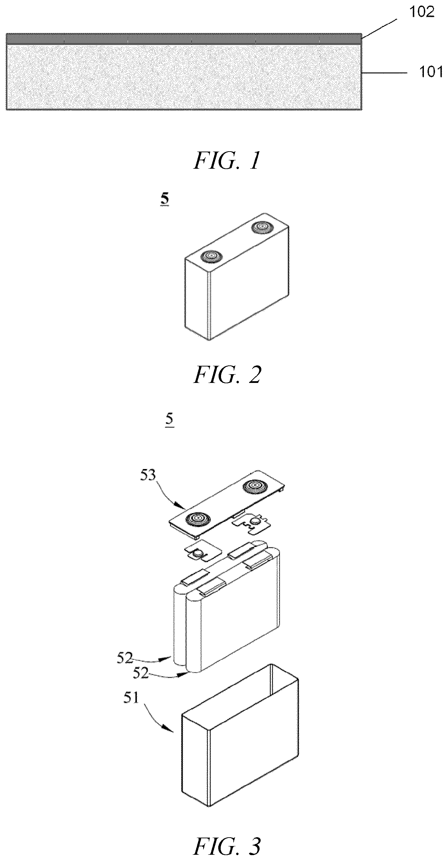

Fig. 1 is a schematic diagram of a prelithiated positive electrode current collector of an embodiment of the present application. As shown in Fig. 1, the prelithiated positive electrode current collector of the present application comprises an aluminum foil layer 101 and a lithium-aluminum alloy layer 102 formed on the above-mentioned aluminum foil layer.

The shape of the lithium-ion battery is not particularly limited in the present application and can be a cylindrical shape, a square shape or any other shape. For example, Fig. 2 shows a lithium-ion battery 5 with a square structure as an example.

In some embodiments, with reference to Fig. 3, the outer package may comprise a housing 51 and a cover plate 53. Herein, the housing 51 may comprise a bottom plate and side plates connected to the bottom plate, and the bottom plate and the side plates enclose to form an accommodating cavity. The housing 51 has an opening in communication with the accommodating cavity, and the cover plate 53 can cover the opening to close the above-mentioned accommodating cavity. The positive electrode plate, the negative electrode plate, and the separator may be subjected to a winding process or a laminating process to form an electrode assembly 52. The electrode assembly 52 is encapsulated in the accommodating cavity. The electrolyte solution infiltrates the electrode assembly 52. The number of the electrode assemblies 52 contained in the lithium-ion battery 5 may be one or more and can be selected by those skilled in the art according to specific actual requirements.

In some embodiments, a lithium-ion battery can be assembled into a battery module, and the number of the lithium-ion batteries contained in the battery module may be one or more, and the specific number can be selected by those skilled in the art according to the application and capacity of the battery module.

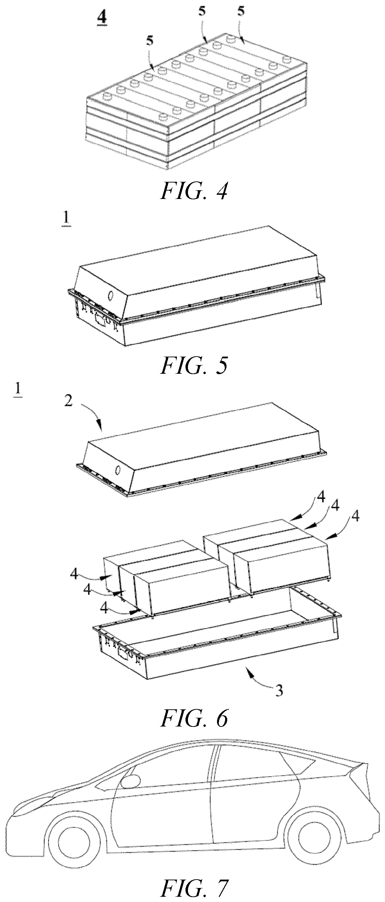

FIG. 4 shows a battery module 4 as an example. Referring to Fig. 4, in the battery module 4, a plurality of lithium-ion batteries 5 may be arranged in sequence in the lengthwise direction of the battery module 4. Apparently, the secondary batteries may also be arranged in any other manner. Furthermore, the plurality of lithium-ion batteries 5 may be fixed by fasteners.

Optionally, the battery module 4 may further comprise an outer shell with an accommodating space, and the plurality of lithium-ion batteries 5 are accommodated in the accommodating space.

In some embodiments, the above-mentioned battery module may be further assembled into a battery pack, the number of the battery modules contained in the battery pack may be one or more, and the specific number can be selected by those skilled in the art according to the application and capacity of the battery pack.

Figs. 5 and 6 show a battery pack 1 as an example. Referring to Figs. 5 and 6, the battery pack 1 may comprise a battery box and a plurality of battery modules 4 arranged in the battery box. The battery box comprises an upper box body 2 and a lower box body 3, wherein the upper box body 2 may cover the lower box body 3 to form a closed space for accommodating the battery modules 4. The plurality of the battery modules 4 may be arranged in the battery box in any manner.

In addition, the present application further provides a power consuming device comprising at least one of the lithium-ion battery, battery module, or battery pack provided by the present application. The above-mentioned lithium-ion battery, battery module or battery pack may be used as a power source of the power consuming device or as an energy storage unit of the above-mentioned power consuming device. The power consuming device may include, without limitation, a mobile device (e.g., a mobile phone or a laptop computer), an electric vehicle (e.g., a pure electric vehicle, a hybrid electric vehicle, a plug-in hybrid electric vehicle, an electric bicycle, an electric scooter, an electric golf cart, or an electric truck), an electric train, a ship, a satellite, an energy storage system, etc.

For the above-mentioned power consuming device, the lithium-ion battery, the battery module or the battery pack can be selected according to the usage requirements.

Fig. 7 shows a power consuming device as an example. The power consuming device may be a pure electric vehicle, a hybrid electric vehicle, a plug-in hybrid electric vehicle, etc. In order to meet the requirements of the power consuming device for a high power and a high energy density of a lithium-ion battery, the battery pack or the battery module may be used.

As another example, the device may be a mobile phone, a tablet computer, a laptop computer, etc. The device is generally required to be thin and light and may use a lithium-ion battery as a power source.

### Examples

Hereinafter, the examples of the present application will be explained. The examples described below are exemplary and are merely for explaining the present application, and should not be construed as limiting the present application. The examples in which techniques or conditions are not specified are based on the techniques or conditions described in documents in the art or according to the product instructions. The reagents or instruments used therein on which no manufacturers are specified are all commercially available conventional products.

In addition, in the examples and comparative examples, measurement and effect evaluation are performed by the following methods.

### <Confirmation of metal lithium layer and lithium-aluminum alloy layer and measurement of layer thickness>

By means of a cross-sectional EDS test, line scanning was performed on a cross section perpendicular to the thickness direction, a part where only lithium element intensity signals were observed was a metal lithium layer, a part where lithium element and aluminum element intensity signals were observed was a lithium-aluminum alloy layer, and a part where only aluminum element intensity signals were observed was an aluminum foil layer. The point where the strength of the element aluminum reaches 50% of the strength of the element aluminum in the lithium-aluminum alloy layer is defined as the dividing line between the metal lithium layer and the lithium-aluminum alloy layer. When the dividing line was not confirmed, it was considered that no metal lithium layer was present, that is, the metal lithium was converted into the lithium-aluminum alloy layer.

By means of the cross-sectional EDS test, line scanning of the lithium element was performed on a cross section perpendicular to the thickness direction. A position where the intensity of the element lithium was attenuated to 50% of the maximum value of the lithium-aluminum alloy layer was defined as the dividing line between the lithium-aluminum alloy layer and the aluminum layer. Surface scanning was performed on the lithium-aluminum alloy layer by means of a surface EDS test, the mass percentage content of the element lithium was confirmed to be about 8%, the molar ratio of the content of the element lithium to the content of the element aluminum was about 1 : 3, and it can be determined that a lithium-aluminum alloy (Al₃Li) was formed on the surface of the aluminum foil.

### <Test method for charge specific capacity>

A battery was charged to 3.65 V at a constant current of 0.1 C at room temperature and then to 0.05 C at a constant voltage of 3.65 V, and the charge capacity at this time was measured and recorded as Ci.

Charge specific capacity = Ci / (area of positive electrode plate × surface density of positive electrode plate × content of positive electrode active substance)

### <Test method for discharge specific capacity>

The charged battery was discharged to 2.0 V at a constant current of 0.1 C at room temperature, and the discharge capacity at that time was measured and recorded as C₂.

Discharge specific capacity = C₂ / (area of positive electrode plate × surface density of positive electrode plate × content of positive electrode active substance)

### Example 1

Metal lithium powder (Shanghai Oujin Industrial Co., Ltd., 99.9%) was used as a lithium source and placed in an evaporation chamber of a winding vacuum coating machine (Guangrun Vacuum Technology Co., Ltd.), which was filled with argon, and the evaporation chamber was evacuated to 10⁻¹ Pa. Then, the lithium source was gasified by heating to 600°C. Then, a 13 µm aluminum foil was passed through the evaporation chamber at a speed of 33.3 m/min, and the metal lithium was uniformly deposited on a surface of the aluminum foil.

Next, the aluminum foil deposited with the metal lithium was transferred to an annealing chamber protected by argon, heated to 450°C at a heating rate of 1°C/min, maintained at the temperature for 4 hours, and then cooled to room temperature (25°C) again at a cooling rate of 1°C/min, whereupon a lithium-aluminum alloy layer was formed on the surface of the aluminum foil.

The change of the lithium content in the lithium-aluminum alloy layer was measured by means of cross-sectional EDS, it was confirmed that the metal lithium deposited on the surface of the aluminum foil was all converted into a lithium-aluminum alloy, no metal lithium remained, and the thickness of the lithium-aluminum alloy layer was 0.30 µm. The aluminum foil formed with the lithium-aluminum alloy layer was used as a positive electrode current collector.

Preparation conditions for the above-mentioned positive electrode current collector were summarized in Table 1.

Lithium iron phosphate, carbon black, and polyvinylidene fluoride were dispersed in N-methylpyrrolidone at a ratio of 95% : 2.5% : 2.5% and uniformly stirred to prepare a positive electrode slurry with a solid content of 61%, in which the content of a positive electrode active substance was 95%, the positive electrode slurry was then uniformly applied on the surface of the above-mentioned positive electrode current collector according to a coating amount of 220 g/m² on a single side, and the positive electrode current collector was then dried, cold-pressed, and punched to prepare a positive electrode plate with width × height × thickness = 40 mm × 60 mm × 0.182 mm.

Graphite, silicon monoxide, carbon black, sodium carboxymethylcellulose, and styrene butadiene rubber were dispersed in deionized water at a ratio of 88% : 8% : 1% : 1% : 2% and uniformly stirred to prepare a negative electrode slurry with a solid content of 51%, the negative electrode slurry was then uniformly applied on a surface of a 8 µm copper foil according to a coating amount of 75 g/m² on a single side, and then the copper foil was dried, cold-pressed, and punched to prepare a negative electrode plate with width × height × thickness = 43 mm × 63 mm × 0.108 mm.

Ethylene carbonate (EC), dimethyl carbonate (DMC), and diethyl carbonate (DEC) were mixed at a volume ratio of 1 : 1 : 1 to obtain an organic solvent, 0.5% by mass of vinyl ethylene carbonate (VEC), 1% by mass of fluoroethylene carbonate (FEC), and 0.5% by mass of lithium difluoroborate (ODFB) were added, and a fully dried lithium salt (LiPF₆) was then dissolved in the mixed organic solvent to prepare an electrolyte solution with a concentration of 1 mol/L.

The positive electrode plate as prepared above, a PE film with a thickness of 9 µm as a separator, and the negative electrode plate as prepared above were stacked in order and wound to prepare a battery cell. Then, the bare battery cell was placed in an outer packaging shell and dried, the electrolyte solution was then injected, and vacuum packaging, standing, formation, shaping and other procedures were performed to obtain a lithium-ion battery.

The obtained lithium-ion battery were measured for the charge specific capacity of a positive electrode active substance, the discharge specific capacity of the positive electrode active substance, and the actual capacity, respectively. The results were shown in Table 1.

### Examples 2-21

An aluminum foil formed with a lithium-aluminum alloy layer was prepared in the same manner as that in example 1 except that the preparation conditions shown in Table 1 were adjusted. The thickness of the lithium-aluminum alloy layer and the thickness of a metal lithium layer were measured. Besides, the aluminum foil was used as a positive electrode current collector, and a lithium-ion battery was prepared in the same manner as that in Example 1. The charge specific capacity of a positive electrode active substance, the discharge specific capacity of the positive electrode active substance, and the actual capacity were respectively measured. The results were shown in Table 1.

### Comparative Example 1

A lithium-ion battery was prepared in the same manner as that in Example 1 except that a 13 µm aluminum foil was used as a positive electrode current collector. The charge specific capacity of a positive electrode active substance, the discharge specific capacity of the positive electrode active substance, and the actual capacity were respectively measured. The results were shown in Table 1. That is, the positive electrode current collector in Comparative Example 1 was not prelithiated.

### Comparative Example 2

Metal lithium powder (Shanghai Oujin Industrial Co., Ltd., 99.9%) was used as a lithium source and placed in an evaporation chamber of a winding vacuum coating machine (Guangrun Vacuum Technology Co., Ltd.), which was filled with argon, and the evaporation chamber was evacuated to 10⁻¹ Pa. Then, the lithium source was gasified by heating to 600°C. Then, a 13 µm aluminum foil was passed through the evaporation chamber at a speed of 33.3 m/min, and the metal lithium was uniformly deposited on a surface of the aluminum foil.

No high-temperature annealing was performed. The thickness of the lithium-aluminum alloy layer and the thickness of th metal lithium layer were measured in the same manner as in Example 1. Besides, the aluminum foil was used as a positive electrode current collector and a lithium-ion battery was prepared. The charge specific capacity of the positive electrode active substance, the discharge specific capacity of the positive electrode active substance, and the actual capacity were respectively measured. The results were shown in Table 1.

### Comparative Example 3

The metal lithium was uniformly deposited on a surface of the aluminum foil in the same manner as in Comparative Example 2 except that the moving speed of the aluminum foil was adjusted to 6.7 m/min according to the preparation conditions shown in Table 1.

No high-temperature annealing was performed. The thickness of the lithium-aluminum alloy layer and the thickness of th metal lithium layer were measured in the same manner as in Example 1. Besides, the aluminum foil was used as a positive electrode current collector and a lithium-ion battery was prepared. The charge specific capacity of the positive electrode active substance, the discharge specific capacity of the positive electrode active substance, and the actual capacity were respectively measured. The results were shown in Table 1.

**[Table 1]**

| | Moving speed of aluminum foil (m/min) | Heating rate of annealing (°C/min) | Annealing temperature (°C) | Temperature maintaining time (h) | Cooling rate of annealing (°C/min) | Thickness of lithium-aluminum alloy layer (µm) | Thickness of metal lithium layer (µm) | Charge specific capacity of positive electrode active substance (mAh/g) | Discharge specific capacity of positive electrode active substance (mAh/g) |
|---|---|---|---|---|---|---|---|---|---|
| Example 1 | 33.3 | 1 | 450 | 4 | 1 | 0.30 | 0 | 154.6 | 129.9 |
| Example 2 | 20 | 1 | 450 | 4 | 1 | 0.50 | 0 | 156.0 | 131.4 |
| Example 3 | 6.7 | 1 | 200 | 4 | 1 | 0.41 | 0.67 | 155.4 | 130.8 |
| Example 4 | 6.7 | 1 | 300 | 4 | 1 | 0.68 | 0.53 | 157.4 | 132.8 |
| Example 5 | 6.7 | 1 | 400 | 4 | 1 | 1.20 | 0.11 | 161.3 | 136.6 |
| Example 6 | 6.7 | 1 | 450 | 2 | 1 | 1.10 | 0.32 | 160.6 | 135.9 |
| Example 7 | 6.7 | 1 | 450 | 3 | 1 | 1.40 | 0.12 | 162.8 | 138.1 |
| Example 8 | 6.7 | 1 | 450 | 4 | 1 | 1.49 | 0 | 163.5 | 138.8 |
| Example 9 | 6.7 | 2 | 450 | 4 | 1 | 1.42 | 0.11 | 163.0 | 138.3 |
| Example 10 | 6.7 | 1 | 450 | 4 | 2 | 1.38 | 0.23 | 162.7 | 138.0 |
| Example 11 | 6.7 | 1 | 450 | 5 | 1 | 1.49 | 0 | 163.5 | 138.8 |
| Example 12 | 6.7 | 1 | 500 | 2 | 1 | 1.46 | 0 | 163.3 | 138.6 |
| Example 13 | 6.7 | 1 | 500 | 3 | 1 | 1.41 | 0 | 162.9 | 138.2 |
| Example 14 | 6.7 | 1 | 500 | 4 | 1 | 1.36 | 0 | 162.5 | 137.8 |
| Example 15 | 6.7 | 1 | 600 | 2 | 1 | 1.22 | 0 | 161.5 | 136.8 |
| Example 16 | 6.7 | 1 | 150 | 24 | 1 | 0.32 | 1.2 | 154.7 | 130.1 |
| Example 17 | 6.7 | 1 | 700 | 2 | 1 | 1.12 | 0 | 160.7 | 136.0 |
| Example 18 | 6.7 | 1 | 700 | 4 | 1 | 0.83 | 0 | 158.5 | 133.9 |
| Example 19 | 4 | 1 | 450 | 4 | 1 | 2.50 | 0 | 171.0 | 146.3 |
| Example 20 | 3.3 | 1 | 450 | 4 | 1 | 2.97 | 0 | 175.0 | 150.2 |
| Example 21 | 2.9 | 1 | 450 | 4 | 1 | 3.44 | 0 | 178.1 | 149.4 |
| Comparative Example 1 | - | - | - | - | - | 0.00 | 0 | 152.3 | 127.7 |
| Comparative Example 2 | 33.3 | - | - | - | - | 0.10 | 0.16 | 153.1 | 128.4 |
| Comparative Example 3 | 6.7 | - | - | - | - | 0.12 | 1.19 | 153.2 | 128.6 |

In Examples 1-21, most or even all of the deposited metal lithium could be converted into the lithium-aluminum alloy by performing an annealing procedure at an appropriate annealing temperature for an appropriate annealing time, thereby increasing the metal specific capacity of the positive electrode active substance.

In Comparative Example 1, since the metal lithium was not deposited, no lithium-aluminum alloy layer can be formed.

In Comparative Examples 2 and 3, since no high-temperature annealing process was performed, only a small amount of the deposited metal lithium was converted into a lithium-aluminum alloy. Particularly, in Comparative Example 3, since the amount of the deposited lithium was increased, the conversion was more insufficient.

It should be noted that the present application is not limited to the above embodiments. The above embodiments are exemplary only, and any embodiment that has substantially the same constitutions as the technical ideas and has the same effects within the scope of the technical solution of the present application falls within the technical scope of the present application. In addition, without departing from the gist of the present application, various modifications that are made to the embodiments and are conceivable to those skilled in the art, and other modes constructed by combining some of the constituent elements of the embodiments also fall within the scope of the present application.

## Claims

1. A method for preparing a prelithiated positive electrode current collector, **characterized by** comprising the following steps:
gasifying a lithium source in an evaporation chamber filled with a protective gas;
enabling an aluminum foil layer to pass through the evaporation chamber and depositing the metal lithium on a surface of the aluminum foil layer by means of vapor deposition; and
transferring the aluminum foil layer deposited with the metal lithium to an annealing chamber filled with a protective gas and performing high-temperature annealing to form a lithium-aluminum alloy layer on the surface of the aluminum foil layer.

2. The preparation method according to claim 1, **characterized by**
evacuating the evaporation chamber to a vacuum degree of 10⁻⁶ to 10² Pa, heating the lithium source to 300-800°C, and gasifying the lithium source;
optionally, evacuating the evaporation chamber to a vacuum degree of 10⁻² to 10 Pa; and
optionally, heating the lithium source to 500-750°C.

3. The preparation method according to claim 1 or 2, **characterized by**
enabling the aluminum foil layer to pass through the evaporation chamber at a speed of 0.1-100 m/min; and
optionally, enabling the aluminum foil layer to pass through the evaporation chamber at a speed of 1-30 m/min.

4. The preparation method according to any one of claims 1-3, **characterized by**
during the high-temperature annealing, heating same to the highest temperature of 200-600°C at a heating rate of 0.1-10°C/min, maintaining the temperature for a time of 0.1-24 hours, and then cooling same to room temperature at a cooling rate of 0. 1-5°C/min.

5. The preparation method according to claim 4, **characterized in that**
during the high-temperature annealing,
the heating rate is 0.5-3°C/min;
the highest temperature is 400-500°C;
the temperature maintaining time is 2-4 hours; and
the cooling rate is 0.5-2°C/min.

6. The preparation method according to any one of claims 1-5, **characterized in that**
the lithium source is metal lithium powder, metal lithium strips, or metal lithium wires; and
the protective gas is argon or helium.

7. The preparation method according to any one of claims 1-6, **characterized in that**
the thickness of the aluminum foil layer is 5-50 µm, optionally 8-20 µm; and
the thickness of the lithium-aluminum alloy layer is 0.1-10 µm, optionally 0.3-3.5 µm.

8. A positive electrode current collector obtained by using the preparation method according to any one of claims 1-7, **characterized by**
comprising an aluminum foil layer and a lithium-aluminum alloy layer formed on the aluminum foil layer.

9. A lithium-ion battery, **characterized by**
at least having a positive electrode plate, a separator, a negative electrode plate, and an electrolyte solution, wherein
the positive electrode comprises a positive electrode current collector obtained by using the preparation method according to any one of claims 1-7 or the positive electrode current collector according to claim 8.

10. A battery module, **characterized by**
comprising the lithium-ion battery according to claim 9.

11. A battery pack, **characterized by**
comprising the battery module according to claim 10.

12. A power consuming device, **characterized by**
comprising at least one selected from the lithium-ion battery according to claim 9, the battery module according to claim 10, and the battery pack according to claim 11.
